(19) **Europäisches Patentamt / European Patent Office / Office européen des brevets**

(11) **EP 4 496 241 A1**

(12) **EUROPEAN PATENT APPLICATION**
published in accordance with Art. 153(4) EPC

(43) Date of publication:
**22.01.2025 Bulletin 2025/04**

(21) Application number: **22940775.4**

(22) Date of filing: **20.12.2022**

(51) International Patent Classification (IPC):
*H04B 17/382* *(2015.01)*

(52) Cooperative Patent Classification (CPC):
**H04B 17/382**

(86) International application number:
**PCT/CN2022/140325**

(87) International publication number:
**WO 2023/213081 (09.11.2023 Gazette 2023/45)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **05.05.2022  CN 202210478493**

(71) Applicant: **ZTE Corporation**
**Shenzhen, Guangdong  518057 (CN)**

(72) Inventors:
- **LI, Ruimei**
  **Shenzhen, Guangdong 518057 (CN)**
- **LIN, Wei**
  **Shenzhen, Guangdong 518057 (CN)**
- **XU, Xiaojing**
  **Shenzhen, Guangdong 518057 (CN)**
- **XI, Zhicheng**
  **Shenzhen, Guangdong 518057 (CN)**

(74) Representative: **Savi, Massimiliano et al**
**Notarbartolo & Gervasi S.p.A.**
**Viale Achille Papa, 30**
**20149 Milano (IT)**

(54) **SPECTRUM SENSING METHOD, ELECTRONIC DEVICE AND COMPUTER READABLE STORAGE MEDIUM**

(57)    Provided in the present application are a spectrum sensing method, an electronic device, and a computer readable storage medium. The method comprises: determining feature data of a target sub-band; and inputting the feature data into a trained spectrum sensing model to obtain a spectrum sensing result, wherein the spectrum sensing result comprises a first result, the first result being used for indicating whether the target sub-band is occupied, and when the first result indicates that the target sub-band is occupied, the spectrum sensing result further comprises a second result, the second result being used for indicating an angle of occupation of the target sub-band.

Determine feature data of a target sub-band — S110

Input the feature data into a trained spectrum sensing model to obtain a spectrum sensing result — S120

FIG. 1

**Description**

**CROSS-REFERENCE TO RELATED APPLICATION**

This application is filed on the basis of Chinese patent application No. 202210478493.4 filed May 5, 2022, and claims priority to the Chinese patent application, the entire contents of which are incorporated herein by reference.

**TECHNICAL FIELD**

The present disclosure relates to the technical field of communication, and more particularly, to a spectrum sensing method, an electronic device, a computer-readable storage medium, and a computer program product.

**BACKGROUND**

With the continuous advancement of wireless mobile communication systems, spectrum resources are becoming increasingly scarce. The use of a fixed spectrum allocation policy results in that a lot of spectrum resources cannot be fully utilized. Cognitive radio technology can utilize idle spectrum resources in both time and space to improve spectrum efficiency, and has therefore been widely adopted. Spectrum sensing is a key technology in cognitive radio. The purpose of spectrum sensing is to quickly identify an unoccupied idle spectrum in the frequency band and then share or reuse the idle spectrum. Typically, if it is sensed that a spectrum has been occupied by user signals, the spectrum will not be shared or reused. However, in reality, the occupied spectrum is occupied by user signals only at some angles, and is idle at other angles. Therefore, beamforming and other technologies may be adopted to make use of the idle angles of the occupied spectrum for wireless communication, thereby improving spectrum utilization. As a result, identifying available angle information (such as azimuth and pitch) from an occupied spectrum is a critical challenge to be addressed.

**SUMMARY**

Embodiments of the present disclosure provide a spectrum sensing method, an electronic device, a computer-readable storage medium, and a computer program product, to identify available angle information from an occupied spectrum.

In accordance with a first aspect of the present disclosure, an embodiment provides a spectrum sensing method, including:

determining feature data of a target sub-band; and

inputting the feature data into a trained spectrum sensing model to obtain a spectrum sensing result,

the spectrum sensing result includes a first result, the first result being used for indicating whether the target sub-band is occupied; and

in response to the first result indicating that the target sub-band is occupied, the spectrum sensing result further includes a second result, the second result being used for indicating an angle of occupation of the target sub-band.

In accordance with a second aspect of the present disclosure, an embodiment provides an electronic device, including:

a processor and a memory,

the memory stores program instructions which, when executed by the processor, cause the processor to perform the spectrum sensing method in accordance with the first aspect.

In accordance with a third aspect of the present disclosure, an embodiment provides a computer-readable storage medium, storing program instructions which, when executed by a computer, cause the computer to perform the spectrum sensing method in accordance with the first aspect.

In accordance with a fourth aspect of the present disclosure, an embodiment provides a computer program product, storing computer instructions which, when executed by a computer, cause the computer to perform the spectrum sensing method in accordance with the first aspect.

In the embodiments of the present disclosure, feature data of a target sub-band is inputted to a trained spectrum sensing model, and the spectrum sensing model outputs, based on the feature data, a first result indicating whether the target sub-band is occupied and a second result indicating an angle of occupation of the target sub-band. According to the scheme of the embodiments of the present disclosure, firstly, the use of the spectrum sensing model to predict whether the target sub-band is occupied and predict the angle of occupation of the target sub-band can reduce the computational complexity of spectrum sensing. Secondly, according to the embodiments of the present disclosure, not only whether the target sub-band is occupied by a user signal can be sensed, but also the angle of occupation of the target sub-band occupied by the user signal can be sensed, laying a foundation for further making use of angles that have not been occupied by user signals. Thirdly, the spectrum sensing model provided in the embodiments of the present disclosure can perform prediction for a single target sub-band, with high prediction flexibility. Compared with conventional spectrum sensing models which cannot perform prediction without feature data of all sub-bands of the bandwidth, the spectrum sensing model in the embodiments of the present disclosure only needs to process feature data of the target sub-band to be sensed, and data inputted to the spectrum sensing model is of a small number of dimensions, such that the scale of the spectrum sensing model can be reduced, thereby facilitating the deployment of the model and improving the performance of the spectrum sensing model.

**BRIEF DESCRIPTION OF DRAWINGS**

The drawings are provided for a further understanding of the technical schemes of the present disclosure, and constitute a part of the description. The drawings and the embodiments of the present disclosure are used to illustrate the technical schemes of the present disclosure, but are not intended to limit the technical schemes of the present disclosure.

FIG. 1 is a schematic flowchart of a spectrum sensing method according to an embodiment of the present disclosure;

FIG. 2 is a schematic diagram showing division into sub-bands according to an embodiment of the present disclosure;

FIG. 3 is a schematic diagram of a process of determining feature data of a target sub-band according to an embodiment of the present disclosure;

FIG. 4 is a schematic diagram of a process of acquiring first frequency-domain data of the target sub-band according to an embodiment of the present disclosure;

FIG. 5 is a schematic diagram of a process of calculating a horizontal-antenna covariance matrix according to an embodiment of the present disclosure;

FIG. 6 is a schematic diagram of a process of calculating a vertical-antenna covariance matrix according to an embodiment of the present disclosure;

FIG. 7 is a schematic diagram of a process of calculating an all antenna covariance matrix according to an embodiment of the present disclosure;

FIG. 8 is a schematic structural diagram of a spectrum sensing model provided in Example one according to an embodiment of the present disclosure;

FIG. 9 is a schematic structural diagram of a spectrum sensing model provided in Example two according to an embodiment of the present disclosure;

FIG. 10 is a schematic structural diagram of a spectrum sensing model provided in Example three according to an embodiment of the present disclosure;

FIG. 11 is a schematic flowchart of a method for training the spectrum sensing model according to an embodiment of the present disclosure;

FIG. 12 is a schematic diagram of a process of acquiring sample feature data according to an embodiment of the present disclosure;

FIG. 13 is a schematic diagram of a process of acquiring first frequency-domain sample data of the target sub-band according to an embodiment of the present disclosure; and

FIG. 14 is a schematic structural diagram of an electronic device according to an embodiment of the present disclosure.

## DETAILED DESCRIPTION

To make the purposes, technical schemes, and advantages of the present disclosure clear, the present disclosure is described in further detail in conjunction with accompanying drawings and examples. It should be understood that the specific embodiments described herein are merely used for illustrating the present disclosure, and are not intended to limit the scope of the present disclosure.

It should be understood that in the description of the embodiments of the present disclosure, the terms such as "first", "second" and similar expressions are used solely to distinguish technical features, and are not intended to imply relative importance, the number of indicated technical features, or any precedence order among them. The term "at least one" means one or more, and the term "a plurality of" means two or more. The term "and/or" is used for describing an association between associated purposes and representing that three associations may exist. For example, "A and/or B" may indicate that only A exists, only B exists, and both A and B exist, where A and B may be singular or plural. The character "/" generally indicates an "or" relation between the associated purposes. "At least one of" and similar expressions refer to any combination of items listed, including one item or any combination of a plurality of items. For example, at least one of a, b, or c may represent a, b, c, "a and b", "a and c", "b and c", or "a, b, and c", where a, b, and c may be singular or plural.

In addition, the technical features involved in various embodiments of the present disclosure described below can be combined with each other if not in collision.

With the continuous advancement of wireless mobile communication systems, spectrum resources are becoming increasingly scarce. The use of a fixed spectrum allocation policy results in that a lot of spectrum resources cannot be fully utilized. Cognitive radio technology can utilize idle spectrum resources in both time and space to improve spectrum efficiency, and has therefore been widely adopted. Spectrum sensing is a key technology in cognitive radio. The purpose of spectrum sensing is to quickly identify an unoccupied idle spectrum in the frequency band and then share or reuse the idle spectrum.

Among numerous spectrum sensing technologies, spectrum sensing implemented based on deep learning is an important development direction. In related technologies, data of all spectra of a bandwidth is inputted into a spectrum sensing model, and the spectrum sensing model senses which spectra have been occupied and which spectra have not been occupied. Generally, if it is sensed that a spectrum has been occupied by user signals, the spectrum will not be shared or reused. However, in fact, the occupied spectrum is occupied by user signals only at some angles, and is idle at other angles. Therefore, beamforming and other technologies may be adopted to make use of the idle angles of the occupied spectrum for wireless communication. Therefore, how to identify available angle information (such as azimuth and pitch) from an occupied spectrum is a problem to be solved.

To solve the above problems, embodiments of the present disclosure provide a spectrum sensing method, an electronic device, a computer-readable storage medium, and a computer program product, to identify available angle information from an occupied spectrum.

The embodiments described in the present disclosure may be implemented in a communication system, e.g., in at least one of the following systems: a Global System for Mobile Communications (GSM) or any other second generation (2G) cellular communication system, a third-generation (3G) Universal Mobile Telecommunications System (UMTS) system based on basic Wideband Code Division Multiple Access (W-CDMA), a High Speed Packet Access (HSPA) system, a Long Term Evolution (LTE) system, an Advanced LTE system, an IEEE 802.11-based system, an IEEE 802.15-based system, a fifth-generation (5G) mobile or cellular communication system, and/or future mobile communication systems. However, the embodiments are not limited to the systems given by the above examples, and those having ordinary skills in the art can apply the present scheme to other communication systems having necessary attributes.

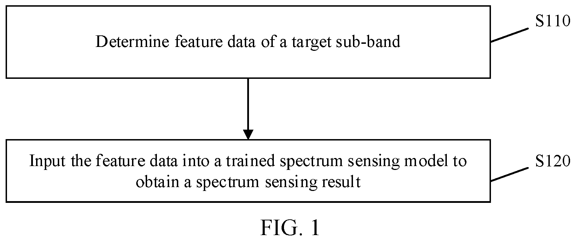

FIG. 1 is a schematic flowchart of a spectrum sensing method according to an embodiment of the present disclosure. An implementation process of the method includes, but not limited to, the following steps S110 to S120, which will be described in sequence below.

At S 110, feature data of a target sub-band is determined.

It can be understood that in the technical scheme of the embodiment of the present disclosure, a full bandwidth is divided into a plurality of sub-bands, where a number of frequency-domain sensing units in each of the sub-bands obtained through the division is less than or equal to a number of frequency-domain sensing units indicated by a frequency-domain sensing granularity. The target sub-band described in S110 is one of the plurality of sub-bands.

For example, the division of the full bandwidth may be realized according to a pre-defined frequency-domain sensing granularity. The frequency-domain sensing granularity may be a resource block granularity. In other words, the full bandwidth is divided into a plurality of sub-bands, where each of the sub-bands obtained through the division includes resource blocks smaller than or equal to a preset resource block granularity in a single slot.

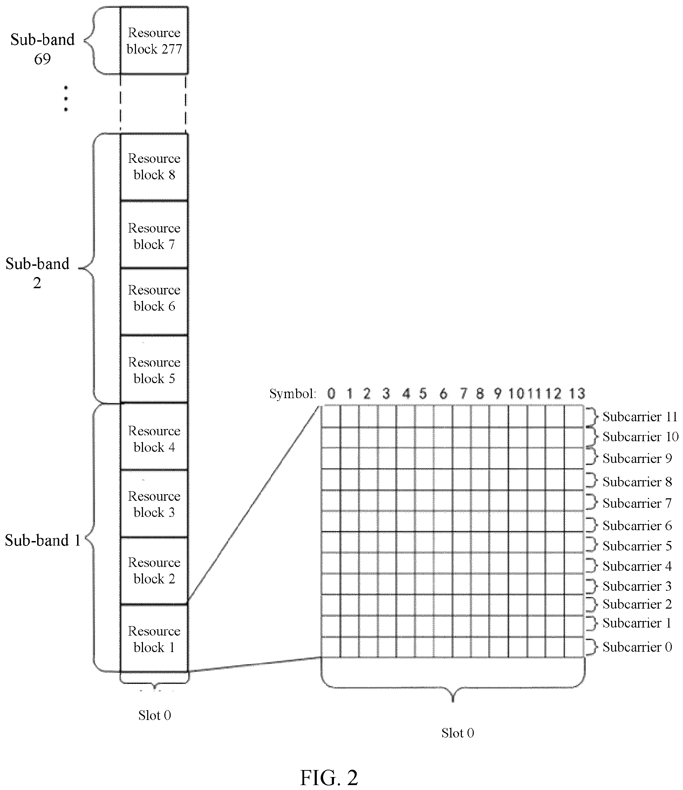

For example, FIG. 2 is a schematic diagram showing division into sub-bands according to an embodiment of the present disclosure. Assuming that the full bandwidth is 100 MHz and the bandwidth of a single subcarrier is 30 kHz, there are a total of 3276 subcarriers in the full bandwidth, and 12 subcarriers are included in a single resource block. In this case, the predefined frequency-domain sensing granularity is 4 resource blocks, i.e., the number of resource blocks included in each sub-band in a single slot should be less than or equal to 4. Therefore, the full bandwidth of 100 MHz can be divided into 69 sub-bands, where one of the sub-bands has a granularity of 1 resource block, and the other sub-bands have a granularity of 4 resource blocks.

It can be understood that after the full bandwidth is divided into a plurality of sub-bands, a target sub-band currently to be sensed may be determined from the plurality of sub-bands. The number of target sub-bands may be one or more

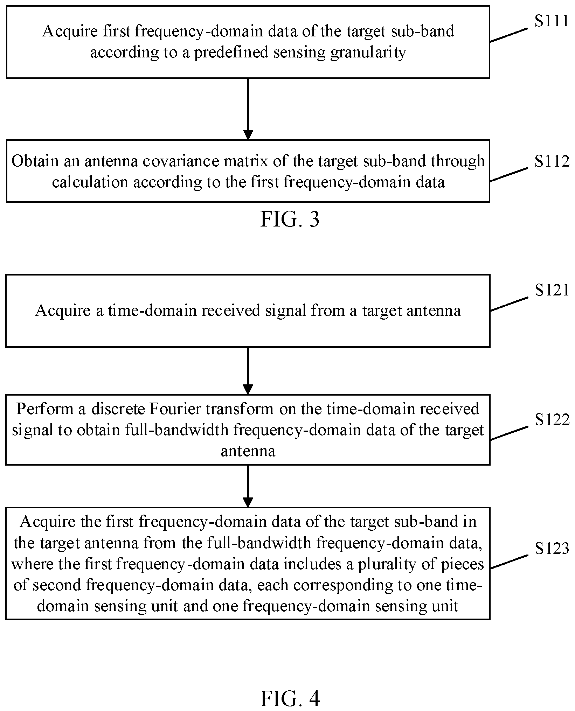

For example, the feature data in the embodiment of the present disclosure may be an antenna covariance matrix. When the feature data is the antenna covariance matrix, as shown in FIG. 3, determining the feature data of the target sub-band may include the following steps S111 to S112.

At Sill, first frequency-domain data of the target sub-band is acquired according to a predefined sensing granularity.

At S112, an antenna covariance matrix of the target sub-band is obtained through calculation according to the first frequency-domain data.

The sensing granularity may include a time-domain sensing granularity and a frequency-domain sensing granularity. The time-domain sensing granularity is used for indicating a number of time-domain sensing units. The frequency-domain sensing granularity is used for indicating a number of frequency-domain sensing units. For example, the time-domain sensing unit is at least one of a slot or a symbol, and the frequency-domain sensing unit is at least one of a resource block or a subcarrier.

FIG. 4 is a schematic diagram of a process of acquiring first frequency-domain data of the target sub-band according to an embodiment of the present disclosure. The process of acquiring the first frequency-domain data includes, but not limited to, the following steps S121 to S123.

At S121, a time-domain received signal is acquired from a target antenna.

It can be understood that the target antenna described in the embodiment of the present disclosure may include a plurality of receiving antennas in an antenna array. Acquiring the time-domain received signal from the target antenna means acquiring a time-domain received signal from each receiving antenna in the antenna array.

At S122, a discrete Fourier transform is performed on the time-domain received signal to obtain full-bandwidth frequency-domain data of the target antenna.

It can be understood that a time-domain signal can be converted into a frequency-domain signal through a discrete Fourier transform, so a discrete Fourier transform may be performed on the time-domain received signal to obtain full-bandwidth frequency-domain data of the target antenna.

At S123, the first frequency-domain data of the target sub-band in the target antenna is acquired from the full-bandwidth frequency-domain data, where the first frequency-domain data includes a plurality of pieces of second frequency-domain data, each corresponding to one time-domain sensing unit and one frequency-domain sensing unit.

It can be understood that the first frequency-domain data of the target sub-band in the target antenna should satisfy the predefined sensing granularity. For example, the first frequency-domain data of the target sub-band in the target antenna includes L*N pieces of second frequency-domain data, each corresponding to one time-domain sensing unit and one frequency-domain sensing unit, where L represents the number of time-domain sensing units, N represents the number of frequency-domain sensing units included in the target sub-band, and L and N are integers greater than 1. For example, the time-domain sensing unit may be a symbol, and when the time-domain sensing granularity is 14 symbols in one slot, L=14. The frequency-domain sensing unit may be a subcarrier, and the frequency-domain sensing granularity is all subcarriers in the target sub-band. Assuming that the target sub-band corresponds to 4 resource blocks, N=48.

It can be understood that the antenna covariance matrix may include a horizontal-antenna covariance matrix, a vertical-antenna covariance matrix, or an all antenna covariance matrix Based on this, obtaining the antenna covariance matrix of the target sub-band through calculation according to the first frequency-domain data includes the following implementations.

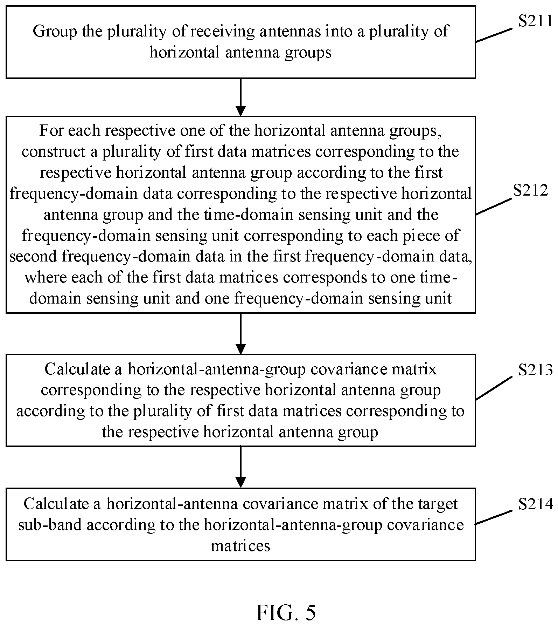

In a first implementation, a horizontal-antenna covariance matrix of the target sub-band is calculated according to the first frequency-domain data. As shown in FIG. 5, a process of calculating the horizontal-antenna covariance matrix may include the following steps S211 to S214.

At S211, the plurality of receiving antennas are grouped into a plurality of horizontal antenna groups.

For example, the antenna array has M receiving antennas arranged in a manner of ±45 degree cross-polarization of Hm horizontal channels and Vm vertical channels, where M=Hm*Vm*2. In this case, all receiving antennas may be divided into Vm*2 horizontal antenna groups, each including Hm horizontal antennas. For another example, if M=64, Hm=8, and Vm=4, all receiving antennas may be divided into 8 horizontal antenna groups each including 8 horizontal antennas.

At S212, for each respective one of the horizontal antenna groups, a plurality of first data matrices corresponding to the respective horizontal antenna group are constructed according to the first frequency-domain data corresponding to the respective horizontal antenna group and the time-domain sensing unit and the frequency-domain sensing unit corresponding to each piece of second frequency-domain data in the first frequency-domain data, where each of the first data matrices corresponds to one time-domain sensing unit and one frequency-domain sensing unit.

For example, the first data matrix may be expressed by the following expression:

$$Hdata_{l,n,x}^{i} = \{ \mathrm{H}data_{l,n,x}^{i,0}, \mathrm{H}data_{l,n,x}^{i,1}, Hdata_{l,n,x}^{i,2}, ... Hdata_{l,n,x}^{i,Hm-1} \}^{\mathrm{T}} \quad (1)$$

The expression (1) represents frequency-domain data of a sub-band x on a current time-domain sensing unit $l$, a current frequency-domain sensing unit n, and an $i^{th}$ horizontal antenna group, where $\{\}^{\mathrm{T}}$ represents a transpose of the matrix.

For example, when the time-domain sensing unit is a symbol and the frequency-domain sensing unit is a subcarrier, the expression (1) represents frequency-domain data of the sub-band x on a current symbol $l$, a current subcarrier n, and the $i^{th}$ horizontal antenna group. The first data matrix is constructed using symbol-level data. Certainly, the first data matrix may also be constructed using slot-level data, which is not particularly limited in the embodiments of the present disclosure.

At S213, a horizontal-antenna-group covariance matrix corresponding to the respective horizontal antenna group is calculated according to the plurality of first data matrices corresponding to the respective horizontal antenna group.

For example, a covariance matrix of the $i^{th}$ horizontal antenna group may be expressed by the following expression:

$$R_{x,H}^{i} = \frac{1}{N*L} \sum_{l=0}^{L-1} \sum_{n=0}^{N-1} Hdata_{l,n,x}^{i} * conj(Hdata_{l,n,x}^{i})^{T} \quad (2),$$

where L represents the number of time-domain sensing units, N represents the number of frequency-domain sensing units included in the target sub-band, and conj represents calculating a conjugate value of a complex number

**[0045]** For example, the time-domain sensing unit is a symbol, and the predefined time-domain sensing granularity is all symbol data in a single slot. When there are 14 symbols in a single slot, the value of L is 14. The frequency-domain sensing unit is a subcarrier, and the frequency-domain sensing granularity is all subcarrier data in the current target sub-band x. When a sub-band granularity of the target sub-band x is 4 resource blocks, and each resource block includes 12 subcarriers, the value of N is 48.

At S214, a horizontal-antenna covariance matrix of the target sub-band is calculated according to the horizontal-antenna-group covariance matrices.

For example, the horizontal-antenna covariance matrix of the target sub-band is obtained by averaging the horizontal-antenna-group covariance matrices corresponding to all the groups. The horizontal-antenna covariance matrix of the sub-band x may be expressed by the following expression:

$$R_{x,H} = \frac{1}{2*Vm} \sum_{i=1}^{2*Vm} R_{x,H}^{i} \quad (3),$$

where Vm represents the number of vertical channels and i represents an $i^{th}$ group of antennas.

It can be understood that the horizontal-antenna covariance matrix $R_{x,H}$ of the sub-band x is a matrix of $Hm * Hm$ dimensions.

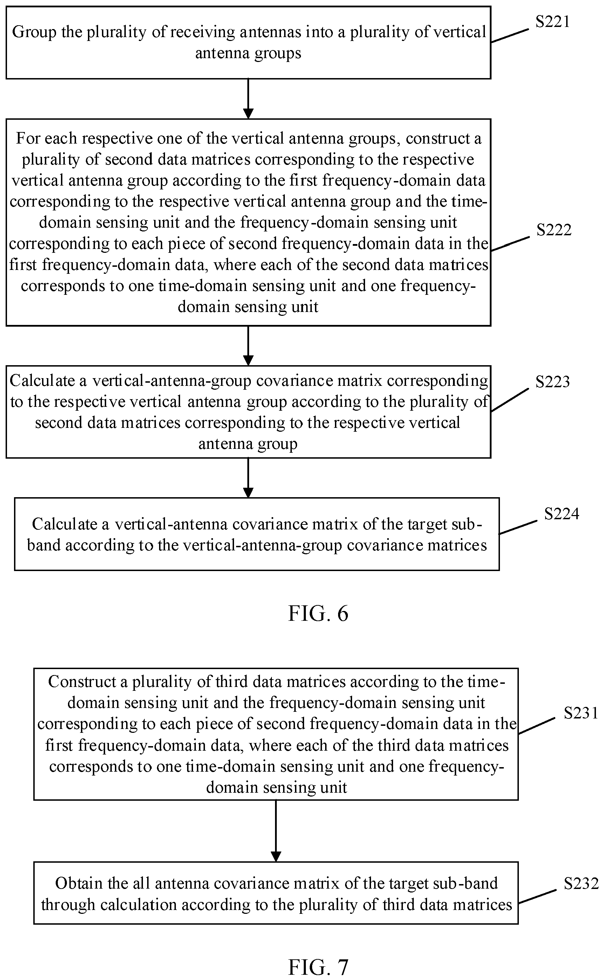

In a second implementation, a vertical-antenna covariance matrix of the target sub-band is calculated according to the first frequency-domain data. As shown in FIG. 6, a process of calculating the vertical-antenna covariance matrix may include the following steps S221 to S224.

At S221, the plurality of receiving antennas are grouped into a plurality of vertical antenna groups.

For example, the antenna array has M receiving antennas arranged in a manner of ±45 degree cross-polarization of Hm horizontal channels and Vm vertical channels, where M=Hm*Vm*2. In this case, all receiving antennas may be divided into Hm*2 vertical antenna groups, each including Vm vertical antennas. For another example, if M=64, Hm=8, and Vm=4, all receiving antennas may be divided into 16 vertical antenna groups each including 4 vertical antennas.

At S222, for each respective one of the vertical antenna groups, a plurality of second data matrices corresponding to the respective vertical antenna group are constructed according to the first frequency-domain data corresponding to the respective vertical antenna group and the time-domain sensing unit and the frequency-domain sensing unit corresponding to each piece of second frequency-domain data in the first frequency-domain data, where each of the second data matrices corresponds to one time-domain sensing unit and one frequency-domain sensing unit.

For example, the second data matrix may be expressed by the following expression:

$$Vdata_{l,n,x}^{i} = \{Vdata_{l,n,x}^{i,0}, Vdata_{l,n,x}^{i,1}, Vdata_{l,n,x}^{i,2}, ... Vdata_{l,n,x}^{i,Vm-1}\}^{\mathrm{T}} \quad (4)$$

The expression (4) represents frequency-domain data of a sub-band x on a current time-domain sensing unit $l$, a current frequency-domain sensing unit n, and an $i^{th}$ vertical antenna group, where $\{\}^{\mathrm{T}}$ represents a transpose of the matrix.

For example, when the time-domain sensing unit is a symbol and the frequency-domain sensing unit is a subcarrier, the expression (4) represents frequency-domain data of the sub-band x on a current symbol $l$, a current subcarrier n, and the $i^{th}$ vertical antenna group. The second data matrix is constructed using symbol-level data. Certainly, the second data matrix may also be constructed using slot-level data, which is not particularly limited in the embodiments of the present disclosure.

At S223, a vertical-antenna-group covariance matrix corresponding to the respective vertical antenna groups is calculated according to the plurality of second data matrices corresponding to the respective vertical antenna group.

For example, a covariance matrix of the $i^{th}$ vertical antenna group may be expressed by the following expression:

$$R_{x,V}^{i} = \frac{1}{N*L} \sum_{l=0}^{L-1} \sum_{n=0}^{N-1} Vdata_{l,n,x}^{i} * conj(Vdata_{l,n,x}^{i})^{T} \quad (5),$$

where L represents the number of time-domain sensing units, N represents the number of frequency-domain sensing units included in the target sub-band, and conj represents calculating a conjugate value of a complex number

**[0058]** For example, the time-domain sensing unit is a symbol, and the predefined time-domain sensing granularity is all symbol data in a single slot. When there are 14 symbols in a single slot, the value of L is 14. The frequency-domain sensing unit is a subcarrier, and the frequency-domain sensing granularity is all subcarrier data in the current target sub-band x. When a sub-band granularity of the target sub-band x is 4 resource blocks, and each resource block includes 12 subcarriers, the value of N is 48.

At S224, a vertical-antenna covariance matrix of the target sub-band is calculated according to the vertical-antenna-group covariance matrices.

For example, the vertical-antenna covariance matrix of the target sub-band is obtained by averaging the vertical-antenna-group covariance matrices corresponding to all the groups. The vertical-antenna covariance matrix of the sub-band x may be expressed by the following expression:

$$R_{x,V} = \frac{1}{2*Hm} \sum_{i=1}^{2*Hm} R_{x,V}^{i} \quad (6),$$

where Hm represents the number of horizontal channels and i represents an $i^{th}$ group of antennas.

It can be understood that the vertical-antenna covariance matrix $R_{x,v}$ of the sub-band x is a matrix of $Vm * Vm$ dimensions.

In a third implementation, an all antenna covariance matrix of the target sub-band is calculated according to the first frequency-domain data. As shown in FIG. 7, a process of calculating the all antenna covariance matrix may include the following steps S231 to S232.

At S231, a plurality of third data matrices are constructed according to the time-domain sensing unit and the frequency-domain sensing unit corresponding to each piece of second frequency-domain data in the first frequency-domain data, where each of the third data matrices corresponds to one time-domain sensing unit and one frequency-domain sensing unit.

For example, the third data matrix may be expressed by the following expression:

$$data_{l,n,x} = \{data^0_{l,n,x}, data^1_{l,n,x}, data^2_{l,n,x}, ...data^{M-1}_{l,n,x}\}^{\mathrm{T}} \quad (7)$$

The expression (7) represents frequency-domain data of a sub-band x on a current time-domain sensing unit *l* and a current frequency-domain sensing unit n, where $\{\}^{\mathrm{T}}$ represents a transpose of the matrix, and M represents the number of receiving antennas in the antenna array.

For example, when the time-domain sensing unit is a symbol and the frequency-domain sensing unit is a subcarrier, the expression (7) represents frequency-domain data of the sub-band x on a current symbol *l* and a current subcarrier n. The third data matrix is constructed using symbol-level data. Certainly, the third data matrix may also be constructed using slot-level data, which is not particularly limited in the embodiments of the present disclosure.

At S232, the all antenna covariance matrix of the target sub-band is obtained through calculation according to the plurality of third data matrices.

For example, the all antenna covariance matrix may be expressed by the following expression:

$$R_x = \frac{1}{N*L} \sum_{l=0}^{L-1} \sum_{n=0}^{N-1} data_{l,n,x} * conj(data_{l,n,x})^T \quad (8),$$

where L represents the number of time-domain sensing units, N represents the number of frequency-domain sensing units included in the target sub-band, and conj represents calculating a conjugate value of a complex number

**[0069]** For example, the time-domain sensing unit is a symbol, and the predefined time-domain sensing granularity is all symbol data in a single slot. When there are 14 symbols in a single slot, the value of L is 14. The frequency-domain sensing unit is a subcarrier, and the frequency-domain sensing granularity is all subcarrier data in the current target sub-band x. When a sub-band granularity of the target sub-band x is 8 resource blocks, and each resource block includes 12 subcarriers, the value of N is 96.

It can be understood that $R_x$ is a matrix of $M * M$ dimensions.

At S120, the feature data is inputted into a trained spectrum sensing model to obtain a spectrum sensing result.

The spectrum sensing result includes a first result, the first result being used for indicating whether the target sub-band is occupied. In a case that the first result indicates that the target sub-band is occupied, the spectrum sensing result further includes a second result, the second result being used for indicating an angle of occupation of the target sub-band.

It can be understood that the feature data inputted to the spectrum sensing model may include any one or more of a horizontal-antenna covariance matrix, a vertical-antenna covariance matrix, or an all antenna covariance matrix

In an implementation, the spectrum sensing model includes a signal energy and angle sensing model. The signal energy and angle sensing model is configured for performing feature extraction of the feature data to obtain a signal energy feature and a signal angle feature, outputting a first result according to the signal energy feature and the signal angle feature, and outputting a second result in a case that the first result indicates that the target sub-band is occupied. It can be understood that the signal energy and angle sensing model is a neural network, which can simultaneously sense signal energy and signal angle.

In another implementation, the spectrum sensing model includes a signal energy sensing model and a signal angle sensing model, where the signal energy sensing model is configured for outputting the first result according to the feature data, and the signal angle sensing model is configured for outputting the second result according to the feature data in a case that the first result indicates that the target sub-band is occupied. It can be understood that the spectrum sensing model includes at least two neural networks, one of the neural networks being configured for sensing signal energy, and the other being configured for sensing signal angle. In a specific implementation, since the feature data inputted to the spectrum sensing model may include two or more types of antenna covariance matrices, the neural network for sensing signal energy may further include two or more sub-neural networks, and similarly, the neural network for sensing signal angle may further include two or more sub-neural networks.

It should be noted that the types of the neural networks used in the implementations of the present disclosure are not limited, which may be a Convolutional Neural Network (CNN), a Recurrent Neural Network (RNN), a Deep Belief Network (DBN), a Generative Adversarial Network (GAN), etc.

Specific examples will be described below.

Example one:

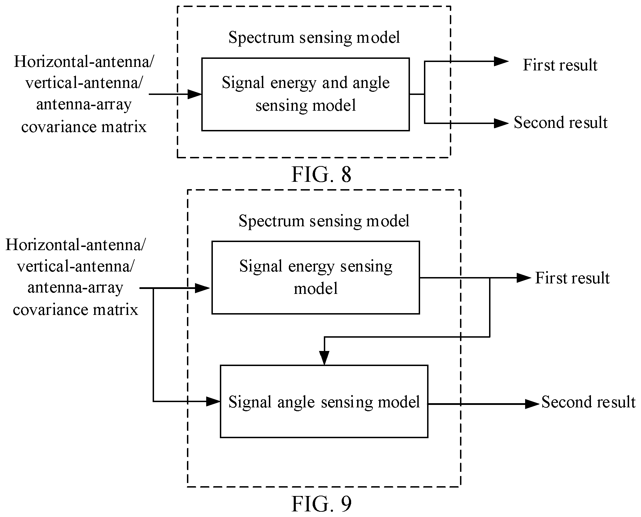

As shown in FIG. 8, in Example one, the spectrum sensing model is the signal energy and angle sensing model, i.e., the spectrum sensing model may include only one neural network. The feature data inputted to the signal energy and angle sensing model includes any one of the horizontal-antenna covariance matrix, the vertical-antenna covariance matrix, and the all antenna covariance matrix of the target sub-band.

It can be understood that when the feature data inputted to the signal energy and angle sensing model is the horizontal-antenna covariance matrix, the signal energy and angle sensing model performs feature extraction on the horizontal-antenna covariance matrix to obtain signal energy features and signal angle features on horizontal antennas. The signal angle features on the horizontal antennas may be understood as azimuth features. Then, according to the signal energy features and the signal angle features on the horizontal antennas, the signal energy and angle sensing model senses whether the target sub-band is occupied by a user signal and senses an angle of occupation of the target sub-band, and outputs a first result and a second result.

It can be understood that when the feature data inputted to the signal energy and angle sensing model is the vertical-antenna covariance matrix, the signal energy and angle sensing model performs feature extraction on the vertical-antenna covariance matrix to obtain signal energy features and signal angle features on vertical antennas. The signal angle features on the vertical antennas may be understood as pitch features. Then, according to the signal energy features and the signal angle features on the vertical antennas, the signal energy and angle sensing model senses whether the target sub-band is occupied by a user signal and senses an angle of occupation of the target sub-band, and outputs the first result and the second result.

It can be understood that when the feature data inputted to the signal energy and angle sensing model is the all antenna covariance matrix, the signal energy and angle sensing model performs feature extraction on the all antenna covariance matrix to obtain signal energy features and signal angle features on all antennas. The signal angle features on all antennas may be understood as a combination of azimuth features and pitch features. Then, according to the signal energy features and the signal angle features on all antennas, the signal energy and angle sensing model senses whether the target sub-band is occupied by a user signal and senses an angle of occupation of the target sub-band, and outputs the first result and the second result.

Example two:

As shown in FIG. 9, in Example two, the spectrum sensing model is a combination of the signal energy sensing model and the signal angle sensing model. The feature data inputted to the spectrum sensing model includes any one of the horizontal-antenna covariance matrix, the vertical-antenna covariance matrix, and the all antenna covariance matrix of the target sub-band.

It can be understood that when the inputted feature data is the horizontal-antenna covariance matrix, first, the signal energy sensing model extracts the signal energy features on the horizontal antennas from the horizontal-antenna covariance matrix, and makes a binary classification prediction according to the signal energy features on the horizontal antennas to determine whether the target sub-band is occupied by a user signal. If the prediction result of the signal energy sensing model (i.e., the first result) indicates that the target sub-band is occupied by a user signal, the signal angle sensing model further extracts the signal angle features (azimuth features) on the horizontal antennas from the horizontal-antenna covariance matrix, predicts angles of occupation of the target sub-band according to the angle energy features on the horizontal antennas, and outputs the second result indicating the angles of occupation. If the prediction result of the signal energy sensing model (i.e., the first result) indicates that the target sub-band is not occupied by a user signal, the signal angle sensing model does not need to make predictions.

It can be understood that when the inputted feature data is the vertical-antenna covariance matrix, first, the signal energy sensing model extracts the signal energy features on the vertical antennas from the vertical-antenna covariance matrix, and makes a binary classification prediction according to the signal energy features on the vertical antennas to determine whether the target sub-band is occupied by a user signal. If the prediction result of the signal energy sensing model (i.e., the first result) indicates that the target sub-band is occupied by the user signal, the signal angle sensing model further extracts the signal angle features (pitch features) on the vertical antennas from the vertical-antenna covariance matrix, predicts angles of occupation of the target sub-band according to the angle energy features on the vertical antennas, and outputs the second result indicating the angles of occupation. If the prediction result of the signal energy sensing model (i.e., the first result) indicates that the target sub-band is not occupied by a user signal, the signal angle sensing model does not need to make predictions.

It can be understood that when the inputted feature data is the all antenna covariance matrix, first, the signal energy sensing model extracts the signal energy features on all antennas from the all antenna covariance matrix, and makes a binary classification prediction according to the signal energy features on all antennas to determine whether the target sub-band is occupied by a user signal. If the prediction result of the signal energy sensing model (i.e., the first result) indicates that the target sub-band is occupied by the user signal, the signal angle sensing model further extracts the signal angle features (azimuth features + pitch features) on all antennas from the all antenna covariance matrix, predicts angles of occupation of the target sub-band according to the angle energy features on all antennas, and outputs the second result indicating the angles of occupation. If the prediction result of the signal energy sensing model (i.e., the first result) indicates that the target sub-band is not occupied by a user signal, the signal angle sensing model does not need to make predictions.

Example three:

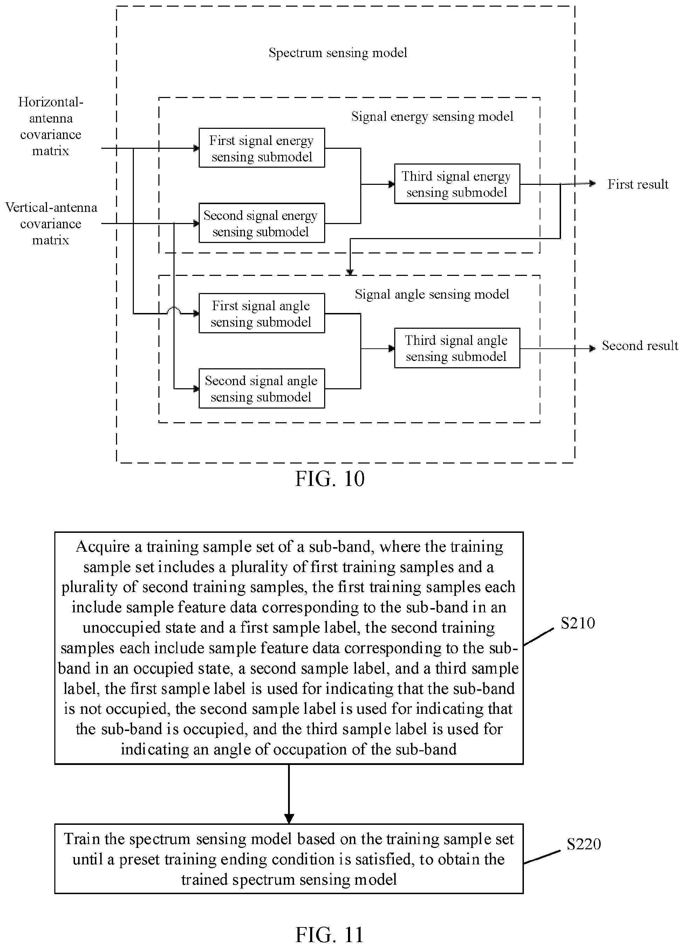

As shown in FIG. 10, in Example three, the spectrum sensing model is a combination of the signal energy sensing model and the signal angle sensing model. The signal energy sensing model includes a first signal energy sensing submodel, a second signal energy sensing submodel, and a third signal energy sensing submodel. The signal angle sensing model includes a first signal angle sensing submodel, a second signal angle sensing submodel, and a third signal angle sensing submodel.

In Example three, the feature data inputted to the spectrum sensing model includes the horizontal-antenna covariance matrix and the vertical-antenna covariance matrix of the target sub-band.

It can be understood that in this example, first, the first signal energy sensing submodel performs feature extraction on the horizontal-antenna covariance matrix and outputs a horizontal antenna energy feature, and the second signal energy sensing submodel performs feature extraction on the vertical-antenna covariance matrix and outputs a vertical antenna energy feature. Then, the third signal energy sensing submodel makes a binary classification prediction according to the horizontal antenna energy feature and the vertical antenna energy feature to determine whether the target sub-band is occupied by a user signal, and outputs the first result. If the first result indicates that the target sub-band is occupied, the first signal angle sensing submodel further performs feature extraction on the horizontal-antenna covariance matrix and outputs a horizontal antenna angle feature (azimuth feature), and the second signal angle sensing submodel performs feature extraction on the vertical-antenna covariance matrix and outputs a vertical antenna angle feature (pitch feature). Then, the third signal angle sensing submodel further predicts the angle of occupation of the target sub-band according to the horizontal antenna angle feature and the vertical antenna angle feature, and outputs the second result. If the first result indicates that the target sub-band is not occupied by a user signal, the signal angle sensing model does not need to make predictions.

According to the scheme of the embodiments of the present disclosure, firstly, the use of the spectrum sensing model to predict whether the target sub-band is occupied and predict the angle of occupation of the target sub-band can reduce the computational complexity of spectrum sensing. Secondly, according to the embodiments of the present disclosure, not only whether the target sub-band is occupied by a user signal can be sensed, but also the angle of occupation of the target sub-band occupied by the user signal can be sensed, laying a foundation for further making use of angles that have not been occupied by user signals. Thirdly, the spectrum sensing model provided in the embodiments of the present disclosure can perform prediction for a single target sub-band, with high prediction flexibility. Compared with conventional spectrum sensing models that cannot perform prediction without feature data of all sub-bands of the bandwidth, the spectrum sensing model in the embodiments of the present disclosure only needs to process feature data of the target sub-band to be sensed, and data inputted to the spectrum sensing model is of a small number of dimensions, such that the scale of the spectrum sensing model can be reduced, thereby facilitating the deployment of the model and improving the performance of the spectrum sensing model.

An embodiment of the present disclosure provides a method for training the spectrum sensing model. FIG. 11 is a schematic flowchart of a method for training the spectrum sensing model. The training method includes the following steps S210 to S220.

At S210, a training sample set of a sub-band is acquired.

The training sample set includes a plurality of first training samples and a plurality of second training samples. The first training samples each include sample feature data corresponding to the sub-band in an unoccupied state and a first label, and the second training samples each include sample feature data corresponding to the sub-band in an occupied state, a second sample label, and a third sample label. The first sample label is used for indicating that the sub-band is not occupied, the second sample label is used for indicating that the sub-band is occupied, and the third sample label is used for indicating an angle of occupation of the sub-band.

It can be understood that, in order to construct the training sample set of the sub-band, two types of sample feature data corresponding to the sub-band should be acquired. The first type of sample feature data is sample feature data corresponding to the sub-band in the unoccupied state, and is correspondingly labeled with the first label (which may be denoted by a digit 1) to form the first training sample. The second type of sample feature data is sample feature data corresponding to the sub-band in the occupied state. In addition, the angle of occupation of the sub-band is also acquired. The angle of occupation of the sub-band is used as the third label. Correspondingly, the sample feature data corresponding to the sub-band in the occupied state is labeled with the second label (which may be denoted by a digit 0) and the third label form the second training sample.

The third label may include an azimuth label and a pitch label. During construction of the training sample set of the sub-band, each second training sample may have a unique azimuth and pitch label. For example, an azimuth range is [-52°, -45°, -37°, -30°, -22°, -15°, -7°, 0°, 7°, 15°, 22°, 30°, 37°, 45°, 52°], and a pitch range is [-10°, -7°, -3°, 0°, 3°, 7°, 10°].

At S220, the spectrum sensing model is trained based on the training sample set until a preset training ending condition is satisfied, to obtain the trained spectrum sensing model.

In a specific training process, the plurality of first training samples and the plurality of second training samples may be respectively inputted into an initial spectrum sensing model, such that the initial spectrum sensing model outputs a prediction result corresponding to each training sample. The prediction result corresponding to each training sample is compared with the corresponding sample label to calculate a loss value. It is determined whether the loss value meets a preset loss threshold. If yes, it can be determined that the preset training ending condition is satisfied, and the training is ended. If not, a model parameter of the spectrum sensing model is adjusted, to continue training of the spectrum sensing model based on the training sample set.

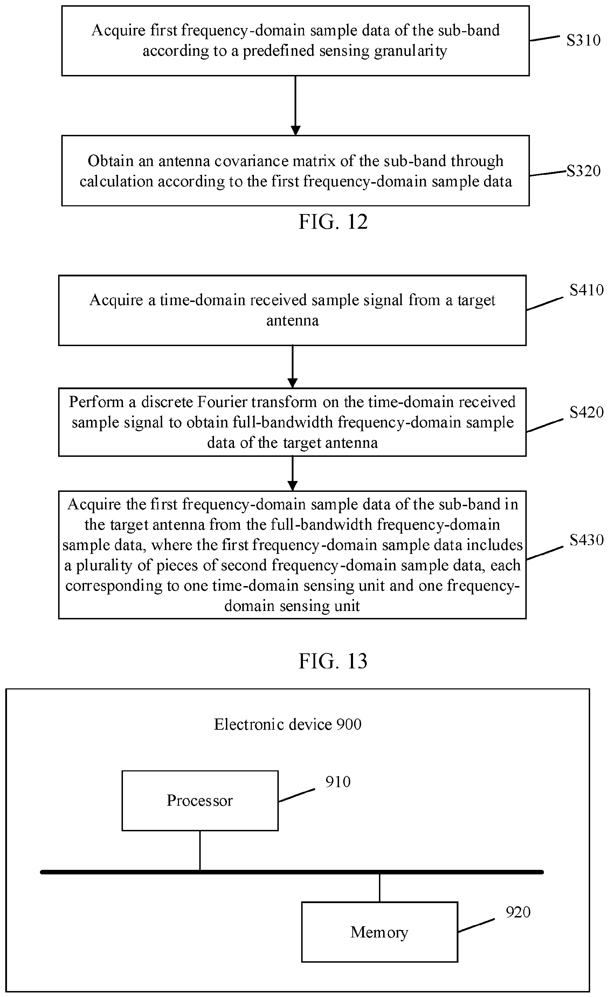

It can be understood that the sample feature data may include an antenna covariance matrix As shown in FIG. 12, a process of acquiring the sample feature data includes the following steps S310 to S320.

At S310, first frequency-domain sample data of the sub-band is acquired according to a predefined sensing granularity.

At S320, an antenna covariance matrix of the sub-band is obtained through calculation according to the first frequency-domain sample data.

It can be understood that in the technical scheme of the embodiment of the present disclosure, a full bandwidth is divided into a plurality of sub-bands, where a number of frequency-domain sensing units in each of the sub-bands obtained through the division is less than or equal to a number of frequency-domain sensing units indicated by a frequency-domain sensing granularity. The sub-band described in S310 is one of the plurality of sub-bands.

For example, the division of the full bandwidth may be realized according to a pre-defined frequency-domain sensing granularity. The frequency-domain sensing granularity may be a resource block granularity. For example, there are a total of 3276 subcarriers in a bandwidth of 100 MHz, and 12 subcarriers are included in a single resource block. The sub-band granularity is predefined to be 4 resource blocks, i.e., the number of resource blocks included in each sub-band in a single slot should be less than or equal to 4. Therefore, the full bandwidth of 100 MHz can be divided into 69 sub-bands, where one of the sub-bands has a granularity of 1 resource block, and the other sub-bands have a granularity of 4 resource blocks.

The sensing granularity in S310 includes a time-domain sensing granularity and a frequency-domain sensing granularity. The time-domain sensing granularity is used for indicating a number of time-domain sensing units. The frequency -domain sensing granularity is used for indicating a number of frequency -domain sensing units.

As shown in FIG. 13, acquiring first frequency-domain sample data of the sub-band according to a predefined sensing granularity includes the following steps S410 to S430.

At S410, a time-domain received sample signal is acquired from a target antenna.

At S420, a discrete Fourier transform is performed on the time-domain received sample signal to obtain full-bandwidth frequency-domain sample data of the target antenna.

At S430, the first frequency-domain sample data of the sub-band in the target antenna is acquired from the full-bandwidth frequency-domain sample data, where the first frequency-domain sample data includes a plurality of pieces of second frequency-domain sample data, each corresponding to one time-domain sensing unit and one frequency-domain sensing unit.

An implementation process of the steps S410 to S430 is similar to that of the steps S121 to S123, so reference may be made to the related description of the steps S121 to S123 for details, which will not be repeated here.

It can be understood that the antenna covariance matrix may include a horizontal-antenna covariance matrix, a vertical-antenna covariance matrix, or an all antenna covariance matrix.

It can be understood that the target antenna includes a plurality of receiving antennas in an antenna array.

When the antenna covariance matrix includes the horizontal-antenna covariance matrix, obtaining an antenna covariance matrix of the sub-band through calculation according to the first frequency-domain sample data may include the following steps S511 to S514.

At S511, the plurality of receiving antennas are grouped into a plurality of horizontal antenna groups.

At S512, for each respective one of the horizontal antenna groups, a plurality of first data matrices corresponding to the respective horizontal antenna group are constructed according to the first frequency-domain sample data corresponding to the respective horizontal antenna group and the time-domain sensing unit and the frequency-domain sensing unit corresponding to each piece of second frequency-domain sample data in the first frequency-domain sample data, where each of the first data matrices corresponds to one time-domain sensing unit and one frequency-domain sensing unit.

At S513, a horizontal-antenna-group covariance matrix corresponding to the respective horizontal antenna group is calculated according to the plurality of first data matrices corresponding to the respective horizontal antenna group.

At S514, a horizontal-antenna covariance matrix of the sub-band is calculated according to the horizontal-antenna-group covariance matrices.

An implementation process of the steps S511 to S514 is similar to that of the steps S211 to S214, so reference may be made to the related description of the steps S211 to S214 for details, which will not be repeated here.

When the antenna covariance matrix includes the vertical-antenna covariance matrix, obtaining an antenna covariance matrix of the sub-band through calculation according to the first frequency-domain sample data may include the following steps S521 to S524.

At S521, the plurality of receiving antennas are grouped into a plurality of vertical antenna groups.

At S522, for each respective one of the vertical antenna groups, a plurality of second data matrices corresponding to the respective vertical antenna group are constructed according to the first frequency-domain sample data corresponding to the respective vertical antenna group and the time-domain sensing unit and the frequency-domain sensing unit corresponding to each piece of second frequency-domain sample data in the first frequency-domain sample data, where each of the second data matrices corresponds to one time-domain sensing unit and one frequency-domain sensing unit.

At S523, a vertical-antenna-group covariance matrix corresponding to the respective vertical antenna groups is calculated according to the plurality of second data matrices corresponding to the respective vertical antenna group.

At S524, a vertical-antenna covariance matrix of the sub-band is calculated according to the vertical-antenna-group covariance matrices.

An implementation process of the steps S521 to S524 is similar to that of the steps S221 to S224, so reference may be made to the related description of the steps S221 to S224 for details, which will not be repeated here.

When the antenna covariance matrix includes the all antenna covariance matrix, obtaining an antenna covariance matrix of the sub-band through calculation according to the first frequency-domain sample data may include the following steps S531 to S532.

At S531, a plurality of third data matrices are constructed according to the time-domain sensing unit and the frequency -domain sensing unit corresponding to each piece of second frequency-domain sample data in the first frequency-domain sample data, where each of the third data matrices corresponds to one time-domain sensing unit and one frequency -domain sensing unit.

At S532, the all antenna covariance matrix of the sub-band is obtained through calculation according to the plurality of third data matrices.

An implementation process of the steps S531 to S532 is similar to that of the steps S231 to S232, so reference may be made to the related description of the steps S231 to S232 for details, which will not be repeated here.

In an implementation, the spectrum sensing model includes a signal energy and angle sensing model, and the signal energy and angle sensing model is configured for performing feature extraction of the sample feature data to obtain a signal energy feature and a signal angle feature, outputting a first result according to the signal energy feature and the signal angle feature, and outputting a second result in a case that the first result indicates that the sub-band is occupied. It can be understood that the signal energy and angle sensing model is a neural network, which can simultaneously sense signal energy and signal angle.

When the spectrum sensing model includes the signal energy and angle sensing model, a process of training the spectrum sensing model may include the following steps S611 to S613.

At S611, the sample feature data in the first training sample is inputted into the signal energy and angle sensing model to obtain a first result corresponding to the first training sample, and a first loss value is calculated according to the first result corresponding to the first training sample and the first label.

At S612, the sample feature data in the second training sample is inputted into the signal energy and angle sensing model to obtain a first result and a second result corresponding to the second training sample, a second loss value is calculated according to the first result corresponding to the second training sample and the second sample label, and a third loss value is calculated according to the second result corresponding to the second training sample and the third sample label.

At S613, it is determined whether the first loss value and the second loss value meet a preset first loss threshold, and it is determined whether the third loss value meets a preset second loss threshold. If the first loss value and the second loss value meet the preset first loss threshold and the third loss value meets the preset second loss threshold, the training is ended. Otherwise, a model parameter of the signal energy and angle sensing model is adjusted, and S611 is repeated to train the signal energy and angle sensing model based on the training sample set.

In another implementation, the spectrum sensing model includes a signal energy sensing model and a signal angle sensing model, where the signal energy sensing model is configured for outputting the first result according to the sample feature data; and the signal angle sensing model is configured for outputting the second result according to the sample feature data in a case that the first result indicates that the sub-band is occupied.

When the spectrum sensing model includes the signal energy sensing model and the signal angle sensing model, a process of training the spectrum sensing model may include the following steps S621 to S625.

At S621, the sample feature data in the first training sample is inputted into the signal energy sensing model to obtain a first result corresponding to the first training sample, and a first loss value is calculated according to the first result corresponding to the first training sample and the first label.

At S622, the sample feature data in the second training sample is inputted into the signal energy sensing model to obtain a first result corresponding to the second training sample, and a second loss value is calculated according to the first result corresponding to the second training sample and the second sample label.

At S623, it is determined whether the first loss value and the second loss value meet a preset first loss threshold. If the first loss value and the second loss value meet the preset first loss threshold, S624 is executed. Otherwise, a model parameter of the signal energy sensing model is adjusted, and S621 is repeated to train the signal energy sensing model based on the training sample set.

At S624, the sample feature data in the second training sample is inputted into the signal angle sensing model to obtain a second result corresponding to the second training sample, and a third loss value is calculated according to the second result corresponding to the second training sample and the third sample label.

At S625, it is determined whether the third loss value meets a preset second loss threshold. If the third loss value meets the preset second loss threshold, the training is ended. Otherwise, a model parameter of the signal angle sensing model is adjusted, and S624 is repeated to train the signal angle sensing model based on the training sample set.

In still another implementation, sample feature data in each training sample includes a horizontal-antenna covariance matrix and a vertical-antenna covariance matrix, and the spectrum sensing model is a combination of a signal energy sensing model and a signal angle sensing model. The signal energy sensing model includes a first signal energy sensing submodel, a second signal energy sensing submodel, and a third signal energy sensing submodel. The signal angle sensing model includes a first signal angle sensing submodel, a second signal angle sensing submodel, and a third signal angle sensing submodel.

The first signal energy sensing submodel is configured for performing feature extraction on the horizontal-antenna covariance matrix and outputting a horizontal antenna energy feature. The second signal energy sensing submodel is configured for performing feature extraction on the vertical-antenna covariance matrix and outputting a vertical antenna energy feature. The third signal energy sensing submodel is configured for outputting the first result according to the horizontal antenna energy feature and the vertical antenna energy feature.

The first signal angle sensing submodel is configured for performing feature extraction on the horizontal-antenna covariance matrix and outputting a horizontal antenna angle feature. The second signal angle sensing submodel is configured for performing feature extraction on the vertical-antenna covariance matrix and outputting a vertical antenna angle feature. The third signal angle sensing submodel is configured for outputting the second result according to the horizontal antenna angle feature and the vertical antenna angle feature.

In this implementation, a process of training the spectrum sensing model may include the following steps S631 to S635.

At S631, the horizontal-antenna covariance matrix in the first training sample is inputted into the first signal energy sensing submodel, and the vertical-antenna covariance matrix in the first training sample is inputted into the second signal energy sensing submodel, such that the third signal energy sensing submodel outputs a first result corresponding to the first training sample, and calculates a first loss value according to the first result corresponding to the first training sample and the first label.

At S632, the horizontal-antenna covariance matrix in the second training sample is inputted into the first signal energy sensing submodel, and the vertical-antenna covariance matrix in the second training sample is inputted into the second signal energy sensing submodel, such that the third signal energy sensing submodel outputs a first result corresponding to the second training sample, and calculates a second loss value according to the first result corresponding to the second training sample and the second sample label.

At S633, it is determined whether the first loss value and the second loss value meet a preset first loss threshold. If the first loss value and the second loss value meet the preset first loss threshold, S634 is executed. Otherwise, a model parameter of each submodel in the signal energy sensing model is adjusted, and S631 is repeated to train the signal energy sensing model based on the training sample set.

At S634, the horizontal-antenna covariance matrix in the second training sample is inputted into the first signal angle sensing submodel, and the vertical-antenna covariance matrix in the second training sample is inputted into the second signal angle sensing submodel, such that the third signal angle sensing submodel outputs a second result corresponding to the second training sample, and calculates a third loss value according to the second result corresponding to the second training sample and the third sample label.

At S635, it is determined whether the third loss value meets a preset second loss threshold. If the third loss value meets the preset second loss threshold, the training is ended. Otherwise, a model parameter of each submodel in the signal angle sensing model is adjusted, and S634 is repeated to train the signal angle sensing model based on the training sample set.

It should be noted that in the embodiments of the present disclosure, the number of sub-bands may be more than one, i.e., there may be training sample sets of a plurality of sub-bands, and the spectrum sensing model is trained according to the training sample sets of the plurality of sub-bands, such that the trained spectrum sensing model can perform spectrum sensing on the plurality of sub-bands. For example, when there are 69 sub-bands in a bandwidth of 100 M, a training sample set is constructed for each of the 69 sub-bands, and the spectrum sensing model is trained based on all the training sample sets, such that the spectrum sensing model can achieve spectrum sensing of all the sub-bands within the full bandwidth.

It should be noted that although the operations in the embodiments of the present disclosure are described in a particular order in the drawings, it should not be construed as requiring that these operations be performed in a particular or serial order as shown, or that all of the illustrated operations be performed to achieve a desired result. In a particular environment, multitasking and parallel processing may be advantageous.

In addition, in the embodiments of the present disclosure, the description in each embodiment has its own focus. For parts that are not detailed or set forth in one embodiment, reference may be made to the relevant descriptions in other embodiments.

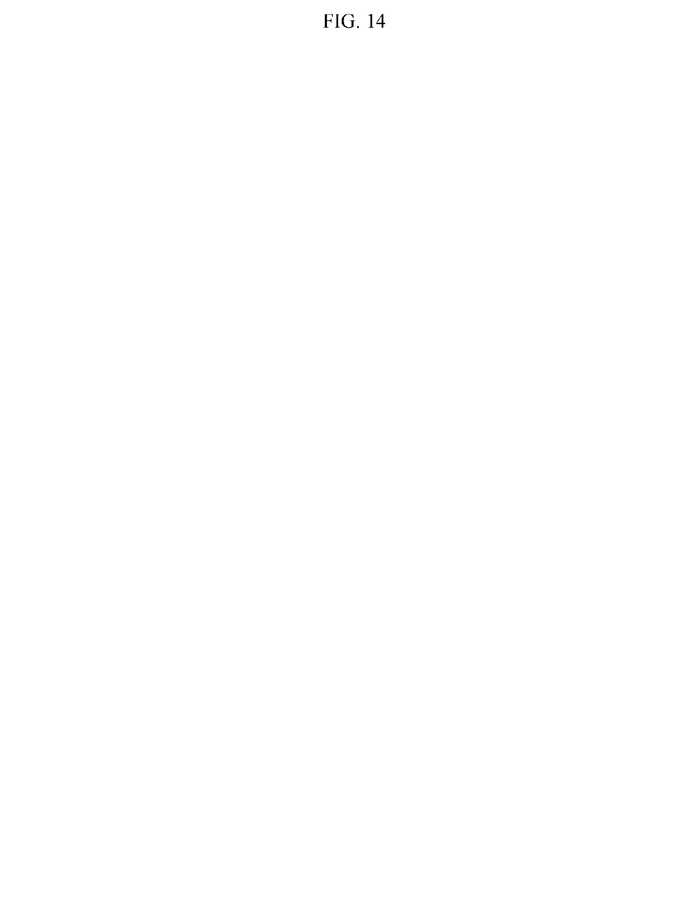

An embodiment of the present disclosure provides an electronic device. As shown in FIG. 14, the electronic device 900 includes, but is not limited to,

a processor 910 and a memory 920.

The memory 920 stores program instructions which, when executed by the processor 910, cause the processor 910 to execute the spectrum sensing method according to any one of the above embodiments.

The processor 910 and the memory 920 may be connected by a bus or in other ways.

It can be understood that the processor 910 may be a Central Processing Unit (CPU). The processor may also be other general-purpose processor, a Digital Signal Processor (DSP), an Application-Specific Integrated Circuit (ASIC), a Field Programmable Gate Array (FPGA), or other programmable logic device, discrete gate or transistor logic device, discrete hardware component, or the like. The general-purpose processor may be a microprocessor or any conventional processor or the like. Alternatively, the processor 910 uses one or more integrated circuits for executing related programs to implement the technical schemes provided in the embodiments of the present disclosure.

The memory 920, as a non-transitory computer-readable storage medium, may be configured for storing a non-transitory software program and a non-transitory computer-executable program, for example, the spectrum sensing method described in any one of the embodiments of the present disclosure. The processor 910 runs the non-transitory software program and the non-transitory computer-executable program stored in the memory 920, to implement the spectrum sensing method.

The memory 920 may include a program storage area and a data storage area. The program storage area may store an operating system, and an application required by at least one function. The data storage area may store data and the like required for executing the spectrum sensing method or the method for training a spectrum sensing model. In addition, the memory 920 may include a high-speed random access memory, and may also include a non-transitory memory, e.g., at least one magnetic disk storage device, flash memory device, or other non-transitory solid-state storage device. In some implementations, the memory 920 optionally includes memories located remotely from the processor 910, and the remote memories may be connected to the processor 910 via a network. Examples of the network include, but are not limited to, the Internet, an intranet, a local area network, a mobile communication network, and combinations thereof.

The non-transitory software program and instructions required to implement the spectrum sensing method are stored in the memory 920 which, when executed by one or more processors 910, cause the one or more processors 910 to execute the spectrum sensing method according to any one of the embodiments of the present disclosure.

An embodiment of the present disclosure provides a computer-readable storage medium, storing program instructions which, when executed by a computer, cause the computer to implement the spectrum sensing method according to any one of the above embodiments.

The computer-readable storage medium in the embodiment of the present disclosure may be any combination of one or more computer-readable media. The computer-readable medium may be a computer-readable signal medium or a computer-readable storage medium. For example, the computer-readable storage medium may include, but not limited to, an electrical, magnetic, optical, electromagnetic, infrared, or semiconductor system, apparatus, or device, or any combination thereof. Specific examples (non-exclusive list) of the computer-readable storage medium include: an electrical connection having one or more wires, a portable computer disk, a hard disk, a Random Access Memory (RAM), a Read-Only Memory (ROM), an erasable programmable Read-Only Memory (EPROM), a flash memory, an optical fiber, a portable Compact Disc Read-Only Memory (CD-ROM), an optical storage device, a magnetic storage device, or any suitable combination thereof. In the present disclosure, the computer-readable storage medium may be any tangible medium containing or storing a program that may be used by or used in combination with an instruction execution system, apparatus, or device.

The computer-readable signal medium may include a data signal propagated in a baseband or as part of a carrier. The data signal carries computer-readable program code. Such a propagated data signal may be in a variety of forms including, but not limited to, an electromagnetic signal, an optical signal, or any suitable combination thereof. The computer-readable signal medium may also be any computer-readable medium other than a computer-readable storage medium, and may send, propagate, or transmit a program for use by or used in combination with an instruction execution system, apparatus, or device.

**[0160]** The program code contained on the computer-readable medium may be transmitted using any suitable medium, including but not limited to, via wireless transmission, via a wire, via a fiber optic cable, via Radio Frequency (RF), etc., or any suitable combination thereof.

**[0161]** Computer program code for executing the operations of the present disclosure may be compiled in one or more programming languages or a combination of programming languages, including object-oriented programming languages such as Java, Smalltalk, and C++, and conventional procedural programming languages such as the "C" language or similar programming languages. The program code can be entirely executed on a user's computer, partly executed on the user's computer, executed as a separate software package, partly executed on the user's computer and partly executed on a remote computer, or entirely executed on a remote computer or server. In cases involving a remote computer, the remote computer may be connected to the user's computer via any type of network, including a Local Area Network (LAN) or a Wide Area Network (WAN), or may be connected to an external computer (e.g., via an Internet service provided by an Internet service provider).

**[0162]** An embodiment of the present disclosure provides a computer program product, storing a computer instructions which, when executed by a computer, cause the computer to implement the spectrum sensing method according to any one of the above embodiments.

**[0163]** Although some embodiments of the present disclosure have been described above, the present disclosure is not limited to the implementations described above. Those having ordinary skills in the art can make various equivalent modifications or replacements without departing from the scope of the present disclosure. Such equivalent modifications or replacements fall within the scope defined by the claims of the present disclosure.

## Claims

**1.** A spectrum sensing method, comprising:

determining feature data of a target sub-band; and
inputting the feature data into a trained spectrum sensing model to obtain a spectrum sensing result,
wherein the spectrum sensing result comprises a first result, the first result being used for indicating whether the target sub-band is occupied; and
in response to the first result indicating that the target sub-band is occupied, the spectrum sensing result further comprises a second result, the second result being used for indicating an angle of occupation of the target sub-band.

**2.** The method of claim 1, wherein the spectrum sensing model comprises a signal energy and angle sensing model configured for performing feature extraction of the feature data to obtain a signal energy feature and a signal angle feature, outputting the first result according to the signal energy feature and the signal angle feature, and outputting the second result in response to the first result indicating that the target sub-band is occupied.

**3.** The method of claim 1, wherein the spectrum sensing model comprises a signal energy sensing model and a signal angle sensing model, wherein:

the signal energy sensing model is configured for outputting the first result according to the feature data; and
the signal angle sensing model is configured for outputting the second result according to the feature data in response to the first result indicating that the target sub-band is occupied.

**4.** The method of claim 3, wherein the feature data comprises at least one of a horizontal-antenna covariance matrix, a vertical-antenna covariance matrix, or an all antenna covariance matrix

**5.** The method of claim 4, wherein in response to the feature data comprising the horizontal-antenna covariance matrix and the vertical-antenna covariance matrix, the signal energy sensing model comprises:

a first signal energy sensing submodel, configured for performing feature extraction on the horizontal-antenna covariance matrix and outputting a horizontal antenna energy feature;
a second signal energy sensing submodel, configured for performing feature extraction on the vertical-antenna covariance matrix and outputting a vertical antenna energy feature; and
a third signal energy sensing submodel, configured for outputting the first result according to the horizontal antenna energy feature and the vertical antenna energy feature.

6. The method of claim 4, wherein in response to the feature data comprising the horizontal-antenna covariance matrix and the vertical-antenna covariance matrix, the signal angle sensing model comprises:

   a first signal angle sensing submodel, configured for performing feature extraction on the horizontal-antenna covariance matrix and outputting a horizontal antenna angle feature;
   a second signal angle sensing submodel, configured for performing feature extraction on the vertical-antenna covariance matrix and outputting a vertical antenna angle feature; and
   a third signal angle sensing submodel, configured for outputting the second result according to the horizontal antenna angle feature and the vertical antenna angle feature.

7. The method of claim 1, wherein the feature data is an antenna covariance matrix; and
   determining feature data of a target sub-band comprises:

   acquiring first frequency-domain data of the target sub-band according to a predefined sensing granularity; and
   obtaining an antenna covariance matrix of the target sub-band through calculation according to the first frequency-domain data.

8. The method of claim 7, wherein the predefined sensing granularity comprises a time-domain sensing granularity and a frequency-domain sensing granularity, the time-domain sensing granularity is used for indicating a number of time-domain sensing units, and the frequency -domain sensing granularity is used for indicating a number of frequency-domain sensing units; and
   acquiring first frequency-domain data of the target sub-band according to a predefined sensing granularity comprises:

   acquiring a time-domain received signal from a target antenna;
   performing a discrete Fourier transform on the time-domain received signal to obtain full-bandwidth frequency-domain data of the target antenna; and
   acquiring the first frequency-domain data of the target sub-band in the target antenna from the full-bandwidth frequency-domain data, wherein the first frequency-domain data comprises a plurality of pieces of second frequency-domain data, each corresponding to one time-domain sensing unit and one frequency-domain sensing unit.

9. The method of claim 8, wherein the target antenna comprises a plurality of receiving antennas in an antenna array, and the antenna covariance matrix comprises a horizontal-antenna covariance matrix; and
   obtaining an antenna covariance matrix of the target sub-band through calculation according to the first frequency-domain data comprises:

   grouping the plurality of receiving antennas into a plurality of horizontal antenna groups;
   for each respective one of the horizontal antenna groups, constructing a plurality of first data matrices corresponding to the respective horizontal antenna group according to the first frequency-domain data corresponding to the respective horizontal antenna group and the time-domain sensing unit and the frequency-domain sensing unit corresponding to each piece of second frequency-domain data in the first frequency-domain data, wherein each of the first data matrices corresponds to one time-domain sensing unit and one frequency-domain sensing unit;
   calculating a horizontal-antenna-group covariance matrix corresponding to the respective horizontal antenna group according to the plurality of first data matrices corresponding to the respective horizontal antenna group; and
   calculating a horizontal-antenna covariance matrix of the target sub-band according to the horizontal-antenna-group covariance matrices.

10. The method of claim 8, wherein the target antenna comprises a plurality of receiving antennas in an antenna array, and the antenna covariance matrix comprises a vertical-antenna covariance matrix; and
    obtaining an antenna covariance matrix of the target sub-band through calculation according to the first frequency-domain data comprises:

    grouping the plurality of receiving antennas into a plurality of vertical antenna groups;
    for each respective one of the vertical antenna groups, constructing a plurality of second data matrices corresponding to the respective vertical antenna group according to the first frequency -domain data corresponding to the respective vertical antenna group and the time-domain sensing unit and the frequency -domain sensing unit corresponding to each piece of second frequency-domain data in the first frequency-domain data, wherein each of the second data matrices corresponds to one time-domain sensing unit and one frequency-domain sensing unit;

calculating a vertical-antenna-group covariance matrix corresponding to the respective vertical antenna group according to the plurality of second data matrices corresponding to the respective vertical antenna group; and calculating a vertical-antenna covariance matrix of the target sub-band according to the vertical-antenna-group covariance matrices.

11. The method of claim 8, wherein the target antenna comprises a plurality of receiving antennas in an antenna array; the antenna covariance matrix comprises an all antenna covariance matrix; and

obtaining an antenna covariance matrix of the target sub-band through calculation according to the first frequency-domain data comprises:

constructing a plurality of third data matrices according to the time-domain sensing unit and the frequency-domain sensing unit corresponding to each piece of second frequency-domain data in the first frequency-domain data, wherein each of the third data matrices corresponds to one time-domain sensing unit and one frequency-domain sensing unit; and

obtaining the all antenna covariance matrix of the target sub-band through calculation according to the plurality of third data matrices.

12. The method of claim 7, wherein before acquiring first frequency-domain data of the target sub-band according to a predefined sensing granularity, the method further comprises:

dividing a full bandwidth into a plurality of sub-bands, wherein a number of frequency-domain sensing units in each of the sub-bands is less than or equal to a number of frequency-domain sensing units indicated by a frequency-domain sensing granularity.

13. The method of claim 1, wherein a process of training the spectrum sensing model comprises:

acquiring a training sample set of a sub-band, wherein the training sample set comprises a plurality of first training samples and a plurality of second training samples, the first training samples each comprise sample feature data corresponding to the sub-band in an unoccupied state and a first label, the second training samples each comprise sample feature data corresponding to the sub-band in an occupied state, a second sample label, and a third sample label, the first sample label is used for indicating that the sub-band is not occupied, the second sample label is used for indicating that the sub-band is occupied, and the third sample label is used for indicating an angle of occupation of the sub-band; and

training the spectrum sensing model based on the training sample set until a preset training ending condition is satisfied, to obtain the trained spectrum sensing model.

14. The method of claim 13, wherein the spectrum sensing model comprises a signal energy and angle sensing model configured for performing feature extraction of the sample feature data to obtain a signal energy feature and a signal angle feature, outputting the first result according to the signal energy feature and the signal angle feature, and outputting the second result in response to the first result indicating that the sub-band is occupied.

15. The method of claim 13, wherein the spectrum sensing model comprises a signal energy sensing model and a signal angle sensing model, wherein:

the signal energy sensing model is configured for outputting the first result according to the sample feature data; and

the signal angle sensing model is configured for outputting the second result according to the sample feature data in response to the first result indicating that the sub-band is occupied.

16. The method of claim 15, wherein the sample feature data comprises at least one of a horizontal-antenna covariance matrix, a vertical-antenna covariance matrix, or an all antenna covariance matrix

17. The method of claim 16, wherein in response to the sample feature data comprising the horizontal-antenna covariance matrix and the vertical-antenna covariance matrix, the signal energy sensing model comprises:

a first signal energy sensing submodel, configured for performing feature extraction on the horizontal-antenna covariance matrix and outputting a horizontal antenna energy feature;
a second signal energy sensing submodel, configured for performing feature extraction on the vertical-antenna covariance matrix and outputting a vertical antenna energy feature; and
a third signal energy sensing submodel, configured for outputting the first result according to the horizontal antenna energy feature and the vertical antenna energy feature.

18. The method of claim 16, wherein in response to the sample feature data comprising the horizontal-antenna covariance matrix and the vertical-antenna covariance matrix, the signal angle sensing model comprises:

a first signal angle sensing submodel, configured for performing feature extraction on the horizontal-antenna covariance matrix and outputting a horizontal antenna angle feature;
a second signal angle sensing submodel, configured for performing feature extraction on the vertical-antenna covariance matrix and outputting a vertical antenna angle feature; and
a third signal angle sensing submodel, configured for outputting the second result according to the horizontal antenna angle feature and the vertical antenna angle feature.

19. The method of claim 13, wherein the sample feature data is an antenna covariance matrix; and
a process of acquiring the sample feature data comprises:

acquiring first frequency-domain sample data of the sub-band according to a predefined sensing granularity; and
obtaining an antenna covariance matrix of the sub-band through calculation according to the first frequency-domain sample data.

20. The method of claim 19, wherein the predefined sensing granularity comprises a time-domain sensing granularity and a frequency-domain sensing granularity, the time-domain sensing granularity is used for indicating a number of time-domain sensing units, and the frequency -domain sensing granularity is used for indicating a number of frequency-domain sensing units; and
acquiring first frequency-domain sample data of the sub-band according to a predefined sensing granularity comprises:

acquiring a time-domain received sample signal from a target antenna;
performing a discrete Fourier transform on the time-domain received sample signal to obtain full-bandwidth frequency-domain sample data of the target antenna; and
acquiring the first frequency-domain sample data of the sub-band in the target antenna from the full-bandwidth frequency-domain sample data, wherein the first frequency-domain sample data comprises a plurality of pieces of second frequency-domain sample data, each corresponding to one time-domain sensing unit and one frequency -domain sensing unit.

21. The method of claim 20, wherein the target antenna comprises a plurality of receiving antennas in an antenna array, and the antenna covariance matrix comprises a horizontal-antenna covariance matrix; and
obtaining an antenna covariance matrix of the sub-band through calculation according to the first frequency-domain sample data comprises:

grouping the plurality of receiving antennas into a plurality of horizontal antenna groups;
for each respective one of the horizontal antenna groups, constructing a plurality of first data matrices corresponding to the respective horizontal antenna group according to the first frequency-domain sample data corresponding to the respective horizontal antenna group and the time-domain sensing unit and the frequency-domain sensing unit corresponding to each piece of second frequency-domain sample data in the first frequency-domain sample data, wherein each of the first data matrices corresponds to one time-domain sensing unit and one frequency-domain sensing unit;
calculating a horizontal-antenna-group covariance matrix corresponding to the respective horizontal antenna groups according to the plurality of first data matrices corresponding to the respective horizontal antenna group; and
calculating a horizontal-antenna covariance matrix of the sub-band according to the horizontal-antenna-group covariance matrices.

22. The method of claim 20, wherein the target antenna comprises a plurality of receiving antennas in an antenna array, and the antenna covariance matrix comprises a vertical-antenna covariance matrix; and

obtaining an antenna covariance matrix of the sub-band through calculation according to the first frequency-domain sample data comprises:

grouping the plurality of receiving antennas into a plurality of vertical antenna groups;
for each respective one of the vertical antenna groups, constructing a plurality of second data matrices corresponding to the respective vertical antenna group according to the first frequency-domain sample data corresponding to the respective vertical antenna group and the time-domain sensing unit and the frequency-domain sensing unit corresponding to each piece of second frequency-domain sample data in the first frequency-domain sample data, wherein each of the second data matrices corresponds to one time-domain sensing unit and one frequency-domain sensing unit;
calculating a vertical-antenna-group covariance matrix corresponding to the respective vertical antenna groups according to the plurality of second data matrices corresponding to the respective vertical antenna group; and
calculating a vertical-antenna covariance matrix of the sub-band according to the vertical-antenna-group covariance matrices.

23. The method of claim 20, wherein the target antenna comprises a plurality of receiving antennas in an antenna array; the antenna covariance matrix comprises an all antenna covariance matrix; and obtaining an antenna covariance matrix of the sub-band through calculation according to the first frequency-domain sample data comprises:

constructing a plurality of third data matrices according to the time-domain sensing unit and the frequency-domain sensing unit corresponding to each piece of second frequency-domain sample data in the first frequency-domain sample data, wherein each of the third data matrices corresponds to one time-domain sensing unit and one frequency-domain sensing unit; and
obtaining the all antenna covariance matrix of the sub-band through calculation according to the plurality of third data matrices.

24. An electronic device, comprising:

a processor and a memory,
the memory stores program instructions which, when executed by the processor, cause the processor to perform the method of any of claims 1 to 23.

25. A computer-readable storage medium, storing program instructions which, when executed by a computer, cause the computer to perform the method of any of claims 1 to 23.

26. A computer program product, storing computer instructions which, when executed by a computer, cause the computer to perform the method of any of claims 1 to 23.

Determine feature data of a target sub-band — S110

Input the feature data into a trained spectrum sensing model to obtain a spectrum sensing result — S120

FIG. 1

FIG. 2

Acquire first frequency-domain data of the target sub-band according to a predefined sensing granularity — S111

↓

Obtain an antenna covariance matrix of the target sub-band through calculation according to the first frequency-domain data — S112

FIG. 3

Acquire a time-domain received signal from a target antenna — S121

↓

Perform a discrete Fourier transform on the time-domain received signal to obtain full-bandwidth frequency-domain data of the target antenna — S122

↓

Acquire the first frequency-domain data of the target sub-band in the target antenna from the full-bandwidth frequency-domain data, where the first frequency-domain data includes a plurality of pieces of second frequency-domain data, each corresponding to one time-domain sensing unit and one frequency-domain sensing unit — S123

FIG. 4

Group the plurality of receiving antennas into a plurality of horizontal antenna groups — S211

For each respective one of the horizontal antenna groups, construct a plurality of first data matrices corresponding to the respective horizontal antenna group according to the first frequency-domain data corresponding to the respective horizontal antenna group and the time-domain sensing unit and the frequency-domain sensing unit corresponding to each piece of second frequency-domain data in the first frequency-domain data, where each of the first data matrices corresponds to one time-domain sensing unit and one frequency-domain sensing unit — S212

Calculate a horizontal-antenna-group covariance matrix corresponding to the respective horizontal antenna group according to the plurality of first data matrices corresponding to the respective horizontal antenna group — S213

Calculate a horizontal-antenna covariance matrix of the target sub-band according to the horizontal-antenna-group covariance matrices — S214

FIG. 5

Group the plurality of receiving antennas into a plurality of vertical antenna groups ⟋ S221

For each respective one of the vertical antenna groups, construct a plurality of second data matrices corresponding to the respective vertical antenna group according to the first frequency-domain data corresponding to the respective vertical antenna group and the time-domain sensing unit and the frequency-domain sensing unit corresponding to each piece of second frequency-domain data in the first frequency-domain data, where each of the second data matrices corresponds to one time-domain sensing unit and one frequency-domain sensing unit ⟋ S222

Calculate a vertical-antenna-group covariance matrix corresponding to the respective vertical antenna group according to the plurality of second data matrices corresponding to the respective vertical antenna group ⟋ S223

Calculate a vertical-antenna covariance matrix of the target sub-band according to the vertical-antenna-group covariance matrices ⟋ S224

FIG. 6

Construct a plurality of third data matrices according to the time-domain sensing unit and the frequency-domain sensing unit corresponding to each piece of second frequency-domain data in the first frequency-domain data, where each of the third data matrices corresponds to one time-domain sensing unit and one frequency-domain sensing unit ⟋ S231

Obtain the all antenna covariance matrix of the target sub-band through calculation according to the plurality of third data matrices ⟋ S232

FIG. 7

FIG. 8

FIG. 9

FIG. 10

Acquire a training sample set of a sub-band, where the training sample set includes a plurality of first training samples and a plurality of second training samples, the first training samples each include sample feature data corresponding to the sub-band in an unoccupied state and a first sample label, the second training samples each include sample feature data corresponding to the sub-band in an occupied state, a second sample label, and a third sample label, the first sample label is used for indicating that the sub-band is not occupied, the second sample label is used for indicating that the sub-band is occupied, and the third sample label is used for indicating an angle of occupation of the sub-band — S210

Train the spectrum sensing model based on the training sample set until a preset training ending condition is satisfied, to obtain the trained spectrum sensing model — S220

FIG. 11

Acquire first frequency-domain sample data of the sub-band according to a predefined sensing granularity — S310

Obtain an antenna covariance matrix of the sub-band through calculation according to the first frequency-domain sample data — S320

FIG. 12

Acquire a time-domain received sample signal from a target antenna — S410

Perform a discrete Fourier transform on the time-domain received sample signal to obtain full-bandwidth frequency-domain sample data of the target antenna — S420

Acquire the first frequency-domain sample data of the sub-band in the target antenna from the full-bandwidth frequency-domain sample data, where the first frequency-domain sample data includes a plurality of pieces of second frequency-domain sample data, each corresponding to one time-domain sensing unit and one frequency-domain sensing unit — S430

FIG. 13

Electronic device 900

Processor — 910

Memory — 920

FIG. 14

## INTERNATIONAL SEARCH REPORT

| | International application No. |
|---|---|
| | **PCT/CN2022/140325** |

**A. CLASSIFICATION OF SUBJECT MATTER**

H04B17/382(2015.01)i

According to International Patent Classification (IPC) or to both national classification and IPC

**B. FIELDS SEARCHED**

Minimum documentation searched (classification system followed by classification symbols)

IPC: H04B H04W

Documentation searched other than minimum documentation to the extent that such documents are included in the fields searched

Electronic data base consulted during the international search (name of data base and, where practicable, search terms used)

CNABS, CNTXT, ENTXTC, USTXT, WOTXT, 3GPP, CNKI: 信道, 频谱, 频带, 子带, 资源, 空闲, 占用, 感知, 识别, 检测, 模型, 天线, 协方差, 方向, 角度, 训练, channel, frequency, band, sub-band, spectrum, resource, idle, occupancy, used, percept +, identificat+, detect+, model, training, antenna, covariance, direction, angle

**C. DOCUMENTS CONSIDERED TO BE RELEVANT**

| Category* | Citation of document, with indication, where appropriate, of the relevant passages | Relevant to claim No. |
|---|---|---|
| Y | CN 113067653 A (BEIJING UNIVERSITY OF POSTS AND TELECOMMUNICATIONS) 02 July 2021 (2021-07-02) description, paragraphs 79-91 and 182-191, and figure 1 | 1-7, 12-19, 24-26 |
| Y | CN 102291186 A (UNIVERSITY OF ELECTRONIC SCIENCE AND TECHNOLOGY OF CHINA) 21 December 2011 (2011-12-21) abstract, and description, paragraphs 11-207 | 1-7, 12-19, 24-26 |
| Y | CN 110912630 A (UNIVERSITY OF ELECTRONIC SCIENCE AND TECHNOLOGY OF CHINA) 24 March 2020 (2020-03-24) description, paragraphs 4-34 | 1-7, 12-19, 24-26 |
| A | US 2010173586 A1 (SHARED SPECTRUM COMPANY) 08 July 2010 (2010-07-08) entire document | 1-26 |
| A | CN 109039503 A (GUANGDONG UNIVERSITY OF TECHNOLOGY) 18 December 2018 (2018-12-18) entire document | 1-26 |

☐ Further documents are listed in the continuation of Box C. ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **01 March 2023** | **04 March 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

International application No.

**PCT/CN2022/140325**

| Patent document cited in search report | | | Publication date (day/month/year) | Patent family member(s) | | | Publication date (day/month/year) |
|---|---|---|---|---|---|---|---|
| CN | 113067653 | A | 02 July 2021 | CN | 113067653 | B | 14 January 2022 |
| CN | 102291186 | A | 21 December 2011 | CN | 102291186 | B | 01 January 2014 |
| CN | 110912630 | A | 24 March 2020 | CN | 110912630 | B | 14 May 2021 |
| US | 2010173586 | A1 | 08 July 2010 | US | 9538388 | B2 | 03 January 2017 |
| | | | | US | 2017201889 | A1 | 13 July 2017 |
| | | | | US | 9900782 | B2 | 20 February 2018 |
| | | | | US | 2007263566 | A1 | 15 November 2007 |
| | | | | US | 7564816 | B2 | 21 July 2009 |
| | | | | US | 2008095042 | A1 | 24 April 2008 |
| | | | | US | 8027249 | B2 | 27 September 2011 |
| | | | | US | 2008163334 | A1 | 03 July 2008 |
| | | | | US | 8997170 | B2 | 31 March 2015 |
| | | | | US | 2009047920 | A1 | 19 February 2009 |
| | | | | US | 8055204 | B2 | 08 November 2011 |
| | | | | US | 2009268619 | A1 | 29 October 2009 |
| | | | | US | 8184653 | B2 | 22 May 2012 |
| | | | | US | 2010008313 | A1 | 14 January 2010 |
| | | | | US | 8064840 | B2 | 22 November 2011 |
| CN | 109039503 | A | 18 December 2018 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210478493